# EUROPEAN PATENT APPLICATION

(11) **EP 3 598 481 A1**
(43) Date of publication of application: **22.01.2020**
(21) Application number: 18183798.0
(22) Date of filing: 16.07.2018
(51) Int. Cl.: H01L 21/683, H01L 29/66, H01L 23/31

(54) **SEMICONDUCTOR WAFER, SEMICONDUCTOR CHIP, SEMICONDUCTOR COMPONENT AND METHOD OF FABRICATING A SEMICONDUCTOR WAFER**

(71) Applicant: Infineon Technologies Austria AG, 9500 Villach (AT)
(72) Inventor: PRECHTL, Gerhard, 9232 Rosegg (AT); ZECHMANN, Arno, A-9500 Villach (AT)
(74) Representative: Moore, Joanne Camilla

(57) **Abstract**

In an embodiment, a method of fabricating a semiconductor wafer comprises providing a semiconductor wafer comprising a bulk monocrystalline silicon or sapphire substrate having a growth surface and a rear surface that opposes the growth surface, and an epitaxial Group III nitride-based layer on the growth surface of the substrate, the epitaxial Group III nitride-based layer comprising at least one Group III nitride-based device, wherein the substrate has an initial thickness ti, applying a carrier to the epitaxial Group III nitride-based layer, removing portions of the rear side of the substrate whilst the carrier is applied to the epitaxial Group III nitride-based layer, reducing the thickness of the substrate to a thickness t_{f} and producing a worked rear surface, wherein t_{f} < ti and 20 µm ≤ t_{f} < 250 µm.

## Description

### BACKGROUND

In many commercial applications, large area, low-cost and readily available substrates are needed for the deposition and crystal growth of Group III nitride materials and resulting device structures. The substrate may be a non-Group III nitride substrate, for example silicon, silicon carbide or sapphire. Use of a non-Group III nitride substrate typically results in a difference in lattice parameter between the substrate and the Group III nitride material which can lead to the formation of crystal defects in the Group III nitride material layers grown on the substrate. These crystal defects may impair the performance of devices formed using these Group III nitride layers.

The Group III nitride materials are typically epitaxially deposited on the substrate at high temperatures. The lattice parameter mismatch can also build stress within the composite structure which may cause macroscopic deformation of the composite structure at the growth temperatures, for example excessive warp or bow. The resulting deformation may result in physical separation of the wafer from the growth platform. Physical separation of the wafer from the growth platform can lead to mechanical instability of the composite structure within the deposition chambers as well as loss of uniform heating across the composite structure resulting in thickness and compositional nonuniformity in the Group III nitride layers. The impact may be a detrimental loss to fabricated device yields across the wafer and less than optimal designed device performance.

To mitigate these issues, the published patent application US 2012/0223365 A1 discloses a structure including a strain absorbing layer to help absorb strain that arises due to lattice mismatch between the crystal structure of the substrate and the crystal structure of the material grown on the substrate. This strain absorbing layer may include two or more strain-absorbing interlayer transition modules.

However, further improvements to further increase the yield of Group III nitride devices grown on non-Group III nitride substrates are desirable.

### SUMMARY

In an embodiment, a semiconductor wafer comprises a bulk monocrystalline silicon or sapphire substrate comprising a growth surface and a worked rear surface, and an epitaxial Group III nitride-based layer on the growth surface of the bulk monocrystalline substrate, the epitaxial Group III nitride-based layer comprising a Group III nitride-based device. The semiconductor wafer has a thickness t_{w}, wherein 30 µm ≤ t_{w} < 280 µm. A metal layer may be positioned on the worked rear surface.

In an embodiment, a semiconductor chip comprises a bulk monocrystalline silicon or sapphire substrate comprising a growth surface and a worked rear surface, and an epitaxial Group III nitride-based layer on the growth surface of the semiconductor substrate, the epitaxial Group III nitride-based layer comprising a Group III nitride-based device. The semiconductor chip has a thickness t wherein 30 µm ≤ t < 280 µm. A metal layer may be positioned on the worked rear surface

In an embodiment, a semiconductor component comprises a semiconductor chip, a leadframe having a thickness tₗ, and a housing. The semiconductor chip comprises a bulk monocrystalline silicon or sapphire substrate comprising a growth surface and a worked rear surface, and an epitaxial Group III nitride-based layer on the growth surface of the substrate, the epitaxial Group III nitride-based layer comprising a Group III nitride-based device. The semiconductor chip has a thickness t, wherein 30 µm ≤ t < 280 µm and is attached to a die pad of the lead frame and t/tₗ is smaller than 1.3 or greater than 1.9.

In an embodiment, a method of fabricating a semiconductor wafer comprises providing a semiconductor wafer comprising a bulk monocrystalline silicon or sapphire substrate having a growth surface and a rear surface that opposes the growth surface, and an epitaxial Group III nitride-based layer on the growth surface of the silicon or sapphire substrate, the epitaxial Group III nitride-based layer comprising at least one Group III nitride-based device, wherein the silicon or sapphire substrate has an initial thickness tᵢ, applying a carrier to the epitaxial Group III nitride-based layer, removing portions of the rear side of the silicon or sapphire substrate whilst the carrier is applied to the epitaxial Group III nitride-based layer, reducing the thickness of the silicon or sapphire substrate to a thickness t_{f} and producing a worked rear surface, wherein t_{f} < tᵢ and 20 µm ≤ t_{f} < 250 µm.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figures 1A to 1C illustrate the fabrication of a semiconductor wafer by the use of a carrier.
Figures 2A to 2C illustrate the further processing of a wafer produced by the method illustrated in figure 1 according to an embodiment.
Figures 3A to 3C illustrate the further processing of a wafer produced by the method illustrated in figure 1 according to an embodiment.
Figures 4A to 4G illustrate the fabrication of a silicon wafer using a carrier in the form of a tape.
Figure 5 illustrates a schematic cross-sectional view of a semiconductor wafer.
Figure 6 illustrates a schematic cross-sectional view of a semiconductor component including a semiconductor chip.
Figure 7 illustrates a flowchart of a method for fabricating a semiconductor wafer.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As employed in this specification, when an element is referred to as being "applied to" or "attached to" to another element, it can be directly applied to the other element or intervening elements may be present. In contrast, when an element is referred to as being "directly applied to" or "directly attached to" another element, there are no intervening elements present.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. Aluminum gallium nitride and AlGaN refers to an alloy described by the formula AlₓGa₍₁₋ₓ₎N, where 0 < x < 1.

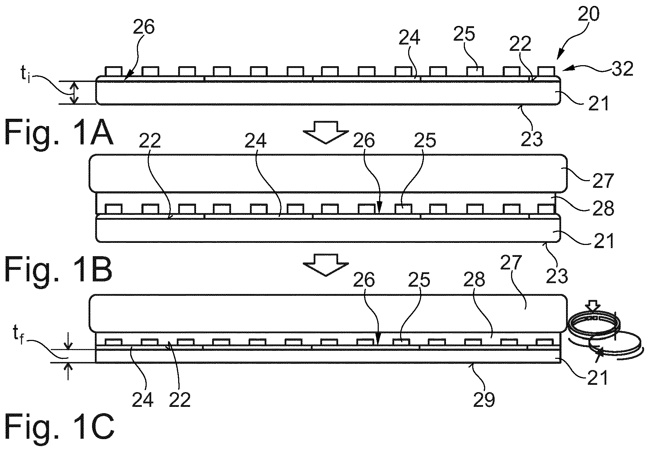

Figures 1A to 1C illustrate a method for fabricating a semiconductor wafer. Figure 1A illustrates a wafer 20 including a substrate 21 having a growth surface 22 and a rear surface 23. The substrate 21 may be a single crystal wafer such as a bulk monocrystalline silicon substrate or a bulk monocrystalline sapphire substrate. The growth surface 22 may be characterised by a surface roughness of less than 1 nm. At least one Group III nitride-based epitaxial layer 24 is arranged on the growth surface 22. The Group III nitride-based epitaxial layer 24 may include two or more sublayers, each comprising a Group III nitride, that are arranged in a stack. The Group III nitride-based epitaxial layer 24 includes one or more Group III nitride-based devices 26 and a metallization structure 25 arranged on the Group III nitride-based epitaxial layer 24. The front side 32 of the wafer is formed from the metallization structure 25 and Group III nitride-based epitaxial layer 24. In some embodiments, one or more passivation layers and/or insulation layers may be arranged on the Group III nitride-based epitaxial layer 24. These passivation layers and/or insulation layers are considered to be part of the metallization structure 25. The passivation and/or insulation layers of the metallization structure 25 may include one or more oxides, for example silicon oxide, one or more nitrides, for example silicon nitride, polyimide or an epoxy resin. The Group III nitride-based epitaxial layer 24 along with the Group III nitride-based devices 26 and metallization structure 25 can be considered to provide a device layer that is arranged on the growth surface 22 of the substrate 21. The wafer 20 can be considered to be a composite wafer. The substrate 21 has a thickness ti which may be 675 µm or more, for example 675 µm to 1200 µm.

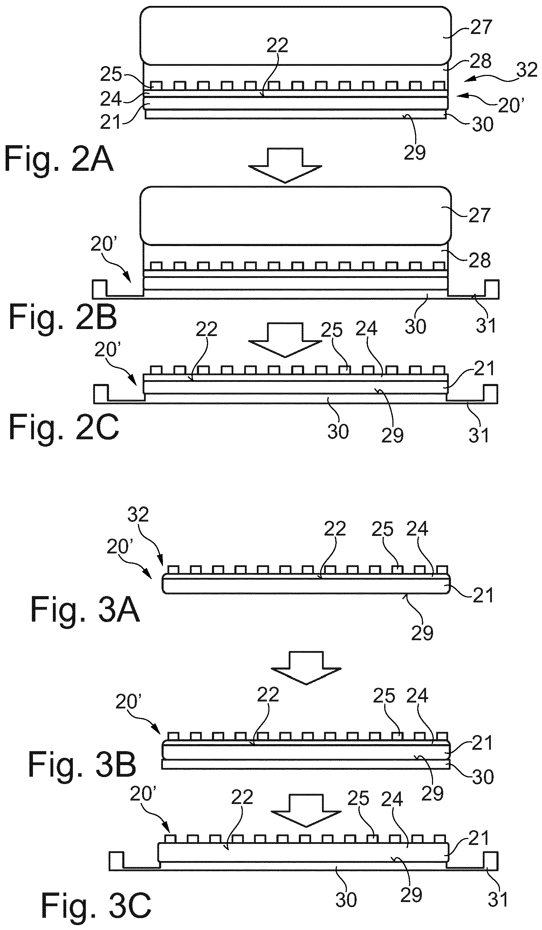

Figure 1B illustrates a carrier applied to the growth surface side of the substrate 21 and to Group III nitride-based layer 24 and metallization structure 25. In the embodiment illustrated in Figure 2B, the carrier is a glass carrier 27 which is attached to the growth surface side of the substrate 20 and to Group III nitride layer 24 and/or metallization structure 25 by a layer of adhesive 28. The rear surface 23 of the substrate 21 is subjected to a grinding and/or polishing and/or etching process so as to reduce the thickness of the substrate to a thickness t_{f} and, therefore, to reduce the thickness of the composite wafer 20 during which a worked rear surface 29 and a thinned composite wafer 20' is produced.

The thinning of the wafer to the thickness t_{f} is illustrated in Figure 1C. The carrier 27 is applied to the composite wafer 20 during the thinning of the substrate 21 and provides mechanical support for the composite wafer 20, also at thicknesses of the substrate 21 that are greater than 250 µm. The worked rear surface 29 is characterised by features such as a surface roughness Rₐ of greater than 1 nm. The thickness t_{f} may lie in the range of 20 µm to less than 250 µm.

The lower limit of the final thickness t_{f} of the substrate may depend on the material of the substrate. In some embodiments, the substrate is a bulk monocrystalline sapphire substrate and the lower limit of the final thickness may be 20 µm so that 20 µm ≤ t_{f} < 250 µm. In embodiments, in which the substrate is a bulk monocrystalline silicon substrate the lower limit of the final thickness may be higher, for example 50 µm so that 50 µm ≤ t_{f} < 250 µm.

The carrier 27 and the adhesive layer 28 may then be removed from the Group III nitride layer 24 and the metallization structure 25 to provide a semiconductor wafer 20'.In some embodiments, a metal layer is applied to the worked second surface 29, as illustrated in Fig. 2C.

The method according to embodiments described herein enables the fabrication of Group III nitride-based devices in the form of a semiconductor wafer that is thinner than a semiconductor wafer produced by other known methods. By using the methods according to the embodiments described herein, Group III nitride-based devices on non-Group III nitride substrates can be provided with a smaller thickness of the non-Group III nitride substrate and, therefore, a smaller thickness of the overall Group III nitride-based device. Alternative methods, which are capable of reliably producing a semiconductor wafer and consequently a semiconductor chip with an epitaxial Group III nitride layer on a silicon substrate or a sapphire substrate and a substrate thickness of less than 250 µm or 100 µm or less and in particular with a minimum thickness of 20 µm of a bulk monocrystalline sapphire substrate or of 50 µm of a bulk monocrystalline silicon substrate are not known to the inventors.

Generally, as the diameter of the wafer increases, reducing the thickness of the substrate to less than 250 µm or 100 µm without significant damage to the devices or substrate itself becomes more difficult to achieve reliably. However, by using the method according to embodiments described herein the reliability and yield of semiconductor chips from a semiconductor wafer having a diameter of 4 inches to 12 inches, in particular 6 inches to 12 inches can also be increased and may be even made possible. Consequently, the method according to embodiments described herein is useful for commercial-scale production.

In some embodiments, for both a silicon and sapphire substrate, the maximum substrate thickness after the thinning process, i.e. the maximum value of t_{f}, may be 250 µm or 100 µm, also for substrates having a diameter of 4 inches to 12 inches, in particular greater than 6 inches.

Therefore, in some embodiments 20 µm ≤ t_{f} < 100 µm, and for a bulk monocrystalline sapphire substrate 20 µm ≤ t_{f} < 100 µm and for a bulk monocrystalline silicon substrate 50 µm ≤ t_{f} < 100 µm. For a bulk monocrystalline sapphire substrate having a diameter d_{w}, wherein 4 inches ≤ d_{w} ≤ 12 inches or 6 inches ≤ d_{w} ≤ 12 inches, the final thickness of the substrate t_{f} may be 20 µm ≤ t_{f} < 250 µm or 20 µm ≤ t_{f} < 100 µm. For a bulk monocrystalline silicon substrate having a diameter d_{w}, wherein 4 inches ≤ d_{w} ≤ 12 inches or 6 inches ≤ d_{w} ≤ 12 inches, the final thickness of the substrate t_{f} may be 50 µm ≤ t_{f} < 250 µm or 20 µm ≤ t_{f} < 100 µm.

Figures 2A to 2C illustrate a method according to an embodiment for further processing the thinned composite wafer 20'. As illustrated in figure 2A, a metal layer 30 is applied to the worked rear surface 29. The metal layer may comprise aluminium, for example. The metal layer 30 may be applied at a lower temperature than that used to epitaxially deposit the Group III nitride layer 24 on the growth surface 22 of the substrate 21. For example, the metal layer 30 may be applied at temperatures of less than 200 °C, whereas the Group III nitride layer 24 may be epitaxially grown at temperatures of above 900°C. In some embodiments, the metal layer 30 includes two or more sublayers which may be of the same or differing composition. In an embodiment, a seed layer is applied to the worked rear surface 29 and one or more further metal layers are applied to the seed layer. The seed layer may be applied using PVD or CVD techniques, for example sputtering. The further metal layer may be applied using CVD or PVD techniques or galvanic techniques.

In some embodiments, as illustrated in figure 2B, the metal layer 30 of the wafer 20' is applied to a dicing tape 31 whilst the carrier is attached to the front side 32 and supports the thinned wafer 20'. As is illustrated in figure 2C, the carrier 27 and adhesive layer 28 are then removed to expose the front side 32 of the thinned wafer 20' and leave the thinned wafer 20' attached to the dicing tape 31. After the thinned wafer 20' is attached to the dicing tape 31 and the carrier 27 is removed, individual semiconductor chips may be separated or singulated from the wafer 20' by inserting a cut into the front surface 32 and, in particular, into the Group III nitride layer 24. The cut extends through the Group III nitride layer 24, the substrate 21 and the metal layer 30 such that the chip is separated or diced from the wafer 20' and is attached to the dicing tape 31. The cut may be inserted by mechanical sawing or laser cutting.

Figures 3A to 3C illustrate an embodiment in which the carrier 27 and the adhesive layer 28 are removed from the Group III nitride layer 24 and metallization 25 to produce a freestanding semiconductor wafer 20' including a worked rear surface 29 comprising silicon or Al₂O₃ and a front side 32 including the metallization structure 25 and the Group III nitride layer 24 as illustrated in figure 3A. As is illustrated in Figure 3B, the metal layer 30 may be applied to the worked second surface 29 of the wafer 20' whilst the wafer 20' is freestanding and detached from the carrier 27.

As is illustrated in Figure 3C, the second metal layer 30 may then be laminated on a dicing tape 31 to attach the thinned wafer 20' to the dicing tape 31. Once the thinned wafer 20' is attached to the dicing tape 31, individual semiconductor chips may be separated or singulated or diced from the wafer 20' by inserting a cut into the first surface 32 and, in particular, into the Group III nitride layer 24. The cut extends through the Group III nitride layer 24, the substrate 21 and the metal layer 30 such that the chip is separated from the wafer 20' and is attached to the dicing tape 31. The cut may be inserted by mechanical sawing or laser cutting.

In embodiments in which a metal layer 30 is not applied to the worked rear surface 29, the worked rear surface 29 of the substrate 21 is applied to the dicing tape 31.

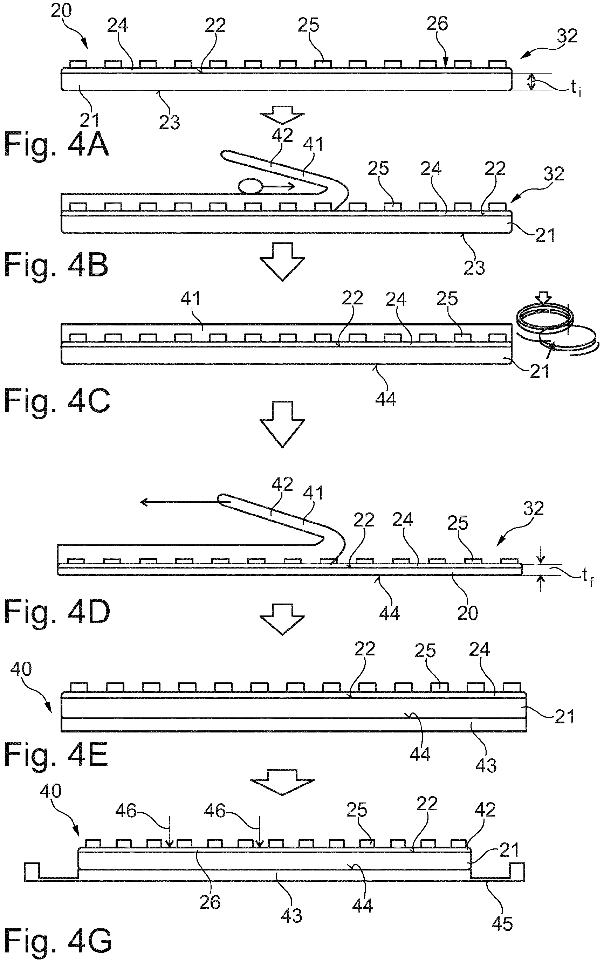

As discussed above, the carrier is not limited to a glass carrier, but may also have other forms such as a tape. Figures 4A to 4G illustrate a method for fabricating a semiconductor wafer 40 according to an embodiment using a carrier in the form of a tape. Figure 4A illustrates the initial semiconductor wafer 20, which includes a bulk monocrystalline silicon substrate 21 having a growth surface 22 and a rear surface 23 and an epitaxial Group III nitride-based layer 24 on the growth surface 22 of the silicon substrate 21. In an alternative embodiments, the substrate 21 is a bulk monocrystalline sapphire (Al₂O₃) substrate having a growth surface 22 and a rear surface 23 and an epitaxial Group III nitride-based layer 24 on the growth surface 22. The wafer 20 may be considered to be a composite wafer and has a metallization structure 25 on its front side 32. The semiconductor wafer has a thickness tᵢ, which is 250 µm or greater.

A carrier 41 in form of an adhesive tape 42 is applied to the front surface 26 of the initial semiconductor wafer 20 such that it is in contact with the metallization structure 25, as illustrated in Figure 4B. Whilst the adhesive tape 42 is attached to the front side 32 of the semiconductor wafer 20, portions of the rear surface 23 of the silicon substrate 21 are removed, for example by grinding, to reduce the initial thickness tᵢ of the silicon substrate 21 to a final thickness t_{f} and produce a worked rear surface 44, as illustrated in Figure 4C. The final thickness t_{f} may lie within the range of 120 µm to 250 µm. The adhesive tape 42 is then removed, as illustrated in Figure 4D, from the thinned semiconductor wafer 40. In some embodiments, such as that illustrated in Figure 4E, a metal layer 43 may be applied to the worked rear surface 44. Either the worked rear surface 44 or the metal layer 43 may then be applied to a dicing tape 45, as illustrated in Figure 4G, to attach the thinned wafer 40 to the dicing tape 45. The semiconductor wafer 40 is singulated into semiconductor chips by inserting cuts from the front side 32 into the Group III nitride-based layer 24, in the direction of the arrows 46, which extend through the silicon substrate 21 and reach the dicing tape 45.

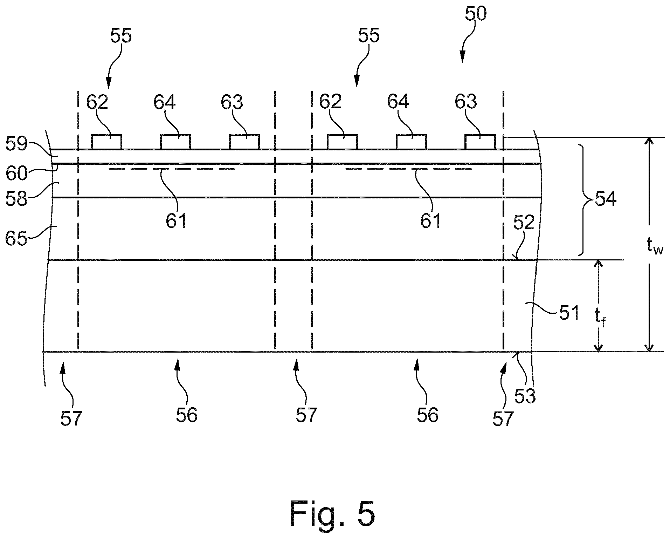

Figure 5 illustrates a schematic view of a portion of a semiconductor wafer 50 which may be fabricated using one of the methods described herein. The semiconductor wafer 50 comprises a bulk monocrystalline silicon substrate 51 comprising a growth surface 52 and a worked rear surface 53. The growth surface 52 may have a <100> or <111> orientation and be prepared so as to support the epitaxial growth of one or more Group III nitride-based layers on the growth surface 52. In contrast, the worked rear surface 53 of the silicon substrate may have surface characteristics which are not capable of supporting the epitaxial growth of a Group III nitride-based layer. The worked rear surface 53 may, for example, have a surface roughness which is greater than 1 nm and be too rough for supporting epitaxial growth.

In an alternative embodiment, the semiconductor wafer 50 comprises a bulk monocrystalline sapphire substrate 51 comprising a growth surface 52 and a rear surface 53, whereby the growth surface 52 of the sapphire substrate 51 is prepared so as to support the epitaxial growth of one or more Group III nitride-based layers on the growth surface 52. The worked rear surface 53 of the sapphire substrate may have surface characteristics which are not capable of supporting the epitaxial growth of a Group III nitride-based layer, for example a surface roughness which is greater than 1 nm.

The semiconductor wafer 50 includes an epitaxial Group III nitride-based layer 54 on the growth surface 52 of the bulk monocrystalline silicon substrate 51. The epitaxial Group III nitride-based layer 54 comprises at least one Group III nitride-based semiconductor device 55. The semiconductor wafer 50 typically includes a plurality of component positions 56, each of which includes at least one Group III nitride-based device 55. The component positions 56 may be arranged in rows and columns and be separated from one another by a region 57 without any active semiconductor devices which may be denoted as a scribe line or saw street.

Typically, the epitaxial Group III nitride-based layer 54 comprises a plurality of sublayers. In some embodiments, the epitaxial Group III nitride-based layer comprises a gallium nitride channel layer 58 and an aluminium nitride barrier layer 59 on the gallium nitride channel layer 58 forming an interface 60 capable supporting a two dimensional charge gas indicated schematically by the dashed line 61 in the drawing. A metallization structure is arranged on the barrier layer 59 may include a source pad 62, a drain pad 63 and a gate pad 64 arranged between the source pad 62 and the drain pad 63 in each component position 56. Such a structure may be used to form a transistor device such as a High Electron Mobility Transistor (HEMT). In some embodiments, further epitaxial Group III nitride layers 65 may be arranged between the growth surface 52 of the silicon substrate 51 and the gallium nitride channel layer 58. These further epitaxial Group III nitride layers 65 may provide a buffer structure.

A typical buffer structure for a silicon substrate includes a AlN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the GaN layer of AlGaN back barrier is grown. Alternatively a superlattice buffer can be used. Again an AlN starting layer on the silicon substrate is used. Depending on the chosen superlattice, a sequence of AlN and AlₓGa₍₁₋ₓ₎N pairs is grown, where the thickness of the AlN layer and AlₓGa₍₁₋ₓ₎N is in the range of 5-15nm. Depending on the desired breakdown voltage the superlattice may include between 20 and 100 pairs. Alternatively, an AlₓGa₍₁₋ₓ₎N layer sequence as described above can be used in combination with the above mentioned super lattice.

The thickness, t_{f}, of the bulk monocrystalline silicon or sapphire substrate 51 may lie in the region of 20 µm to 250 µm. The semiconductor wafer 50 has a thickness, t_{w}, which is greater than the thickness, t_{f}, of the bulk monocrystalline substrate 51 and may have a thickness, t_{w}, that lies within the range of 30 µm to 280 µm. The metallization structure including the source pad 62, drain pad 63 and gate pad 64 may have a thickness of 5 µm to 10 µm. The Group III nitride-based layer 54 may have a thickness of 5 to 30 µm.

Semiconductor chips are singulated from the semiconductor wafer 50 from cutting through the semiconductor wafer 50 in the scribe lines 57, for example by mechanical sawing or laser cutting.

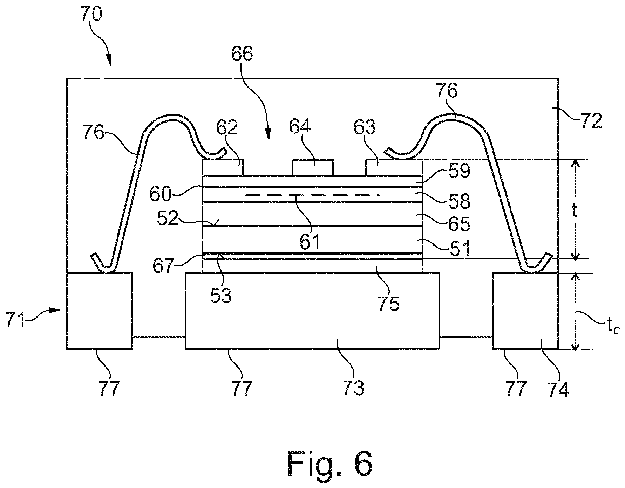

Figure 6 illustrates a semiconductor component 70 including a semiconductor chip 66, a lead frame 71 and a housing 72. The semiconductor chip 66 may be formed from the semiconductor wafer 50 illustrated in Figure 6 by cutting along the scribe lines 57. The semiconductor chip 66 may provide a transistor device such as a HEMT (High Electron Mobility Transistor). The lead frame 71 may include a die pad 73 and one or more leads 74 spaced apart from the die pad. The worked rear surface 53 of the semiconductor chip 66 is mounted on the die pad 73 by an adhesive layer 75 to attach the semiconductor chip 66 to the die pad 73. The adhesive layer 75 may be a soft solder, diffusion solder or conductive adhesive. In embodiments in which the worked rear surface 53 of the semiconductor chip 66 includes a metal layer 67, the metal layer 67 may be used to assist attaching the semiconductor chip 66 to the die pad 73 and/or provide a ground connection. The semiconductor chip 66 is electrically coupled to the leads 74 by connectors 76 which may be provided by one or more bond wires or a contact clip, for example. The housing 72 may include a mould compound, which is typically a cured resin such as a cured epoxy resin. Portions of the leads 74 and optionally the die pad 73 may be exposed from the housing 72 and provide outer contact surface 77 for the semiconductor component 70.

The semiconductor chip 66 has a thickness t which is made up of the thickness of the silicon substrate 51, t_{f}, the thickness of the Group III nitride layer 65, the thickness of the metallization structure 68 and the thickness of the metal layer 67. The thickness t may be 50 µm ≤ t ≤ 280 µm.

The reduced thickness of the semiconductor chip 66 including a Group III nitride-based device on a monocrystalline silicon substrate 50 enables the semiconductor chip 66 to be mounted in packages requiring a thinner chip, such as a ThinPaK type package, and in packages with a recessed die pad, that is the contacts are arranged in a plane above surface of the die pad on which the semiconductor chip is mounted.

The reduced Si substrate thickness can be used to assist in the improvement of the thermal coupling as thinner Si substrate leads to an improvement in the system thermal resistivity. Furthermore, thinning the substrates may be used to assist in reducing package stress, since the stress in the package depends on the silicon to leadframe ratio. To minimize the package stress, a thinner silicon substrate is desirable. This is also the case for a sapphire (Al₂O₃) substrate.

In some embodiments, the ratio of the thickness t of the semiconductor chip 66 and the thickness tₗ of the lead frame 71 is selected such that the ratio t/tₗ is smaller than 1.3 or greater than 1.9. These relationships may be used to improve the reliability of the semiconductor component 70. The ratio t/tₗ may be further defined depending on the material used to attach the semiconductor chip 66 to the die pad 73. For example, the thickness ratio may be less than 1.1 for a soft solder connection, less than 0.9 for a diffusion solder connection and less than 3.1 for a glued connection.

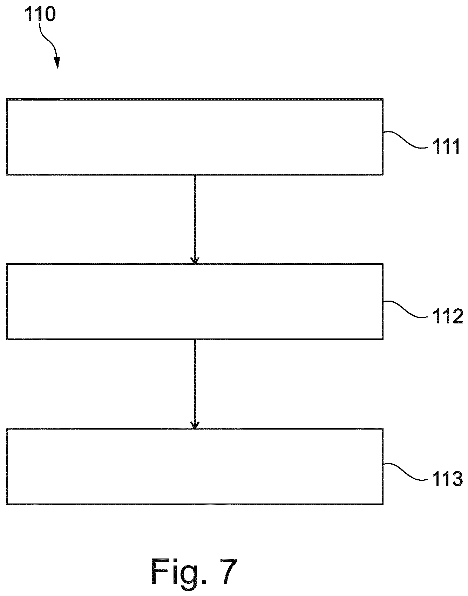

Figure 7 illustrates a flowchart 110 of a method for fabricating a semiconductor wafer. In block 111, a semiconductor wafer is provided which comprises a bulk monocrystalline silicon substrate having a growth surface and a rear surface that opposes the growth surface or a bulk monocrystalline sapphire substrate having a growth surface and a rear surface that opposes the growth surface. An epitaxial Group III nitride-based layer is arranged on the growth surface of the bulk monocrystalline silicon or sapphire substrate. The epitaxial Group III nitride-based layer comprises at least one Group III nitride-based device. The bulk monocrystalline silicon or sapphire substrate has an initial thickness tᵢ. tᵢ may lie in the range of 675 µm to 1200 µm, for example.

In block 112, a carrier is applied to the epitaxial Group III nitride-based layer. In block 113, portions of the rear side of the bulk monocrystalline silicon or sapphire substrate are removed whilst the carrier is applied to the epitaxial Group III nitride-based layer and the thickness of the bulk monocrystalline silicon or sapphire substrate is reduced to a thickness t_{f} and a worked rear surface is produced. The thickness t_{f} is less than the thickness tᵢ, the initial thickness of the silicon substrate. The thickness t_{f} may lie in the region of 20 µm to 250 µm.

The carrier, which is applied to the epitaxial Group III nitride-based layer, provides support for the semiconductor wafer having an epitaxial Group III nitride-based layer arranged on the bulk monocrystalline silicon or sapphire substrate during the thinning of the semiconductor wafer whilst removing portions of the rear side of the substrate to reduce the initial thickness of the substrate, tᵢ, to a final thickness of less than 250 µm.

This method enables the use of standard silicon or sapphire wafers, which are readily available, for example silicon wafers having a diameter of 150 mm to 300 mm and thickness of around 675 µm to 1200 µm. Such standard silicon and sapphire wafers are sufficiently mechanically stable to enable the reliable fabrication of the Group III-nitride based layer and devices on the wafer. After the fabrication of the Group III nitride devices, the thickness of the substrate is reduced, thus reducing the overall thickness of the semiconductor wafer and semiconductor chip to a value that is suitable or desirable for a particular application. The portions of the rear side of the silicon or sapphire substrate may be removed using at least one of the group of processes consisting of grinding, polishing and chemical mechanical polishing.

In the case of a semiconductor wafer including a bulk monocrystalline silicon substrate that is used in the fabrication of a silicon-based device on the silicon substrate, the silicon substrate can be reliably handled and the portions of the rear side of the silicon substrate removed without requiring the support of a carrier layer during the removal process for substrates having an initial thickness tᵢ of 250 µm or more and a final thickness t_{f} of around 100 µm. In contrast, in the case of a semiconductor wafer in which an epitaxial Group III nitride-based layer is grown on the bulk monocrystalline silicon substrate, the use of such a method is found to produce a reduced yield as the bulk monocrystalline silicon substrate is found to be more prone to breakage.

One explanation for this behaviour may be that the high temperatures used to fabricate the Group III nitride layer on the substrate and the mismatch in the coefficient of thermal expansion between the Group III nitride and silicon and between the Group III nitride and sapphire (Al₂O₃) produces a prestress, e.g. at room temperature, in the substrate which leads to a higher breakage rate when the substrate is thinned down. This thinning may be required for the substrate and devices fabricated from the substrate to fit into some packages.

Consequently, for composite semiconductor wafers including a Group III nitride layer on a bulk monocrystalline silicon or sapphire substrate, a carrier is used to support the semiconductor wafer when the silicon substrate has a greater thickness than for semiconductor wafers comprising only silicon. Thus, the yield of Group III nitride devices fulfilling performance criteria obtained from a composite semiconductor wafer is increased without the need for modifying the structure of the Group III layer, for example by including stress-absorbing layers between the Group III nitride device and the silicon substrate.

The support of a carrier is useful if the substrate needs to be thinned down, and if there are process steps required when the wafer is in the thin state, e.g. deposition of backside metallisation or the transport of the thin wafer to the dicing singulation of the chips from the wafer. During a process flow for thick wafers, for example a thickness of 675µm and greater, a support carrier can be omitted.

Whilst a stress absorbing layer within the Group III nitride layer may lead to the system being substantially stress free at the growth temperature, for example 1000°C, so that there is no wafer bow at the growth temperature, upon cooling to room temperature for further processing, the thermal coefficient mismatch between the Group III nitrides and a silicon or sapphire substrate can lead to a stress build up at room temperature. This internal stress can lead to brittleness of the wafers if tensile stress in the layer is accumulated and can also lead to increased wafer bow. The use of the carrier whilst removing portions of the rear side of the bulk monocrystalline silicon or bulk monocrystalline sapphire substrate and reducing the thickness of the bulk monocrystalline silicon or sapphire substrate can enable a stress absorbing layer within the Group III nitride structure to be avoided and can be used to increase the yield of devices fabricated from the wafer.

The epitaxial Group III nitride-based layer may include two or more sublayers each comprising an epitaxial Group III nitride-based layer. In some embodiments, the epitaxial Group III nitride-based layer includes a gallium nitride channel layer and an aluminium gallium nitride barrier layer arranged on the channel layer, which forms an interface with the channel layer which is capable of supporting a two dimensional charge gas. This structure may be used to form a transistor device such as a high electron mobility transistor (HEMT) device. Two or more further sublayers may be arranged between the growth surface of the silicon substrate and the channel layer. The least one Group III nitride-based device typically includes a metallization structure including one or more passivation layers, one or more conductive layers and intervening insulating layers which provides contact pads at its outermost surface. The passivation and/or insulation layers of the metallization structure may include one or more oxides, for example silicon oxide, one or more nitrides, for example silicon nitride, polyimide or an epoxy resin. The carrier may be applied to this metallization structure, including the contact pads.

The Group III nitride-based epitaxial layer with the Group III nitride-based device(s) together with the metallization structure can be considered to be a device layer arranged on the growth surface of the substrate. This device layer forms the front side of the wafer with the rear side of the monocrystalline silicon substrate or monocrystalline sapphire substrate forming the rear side of the wafer.

The carrier is applied to the front side of the semiconductor wafer and onto the Group III nitride layer and metallization structure, if present. The type of carrier may be selected depending on the desired thickness t_{f} of the silicon substrate. In some embodiments, the carrier comprises a tape and 120 µm ≤ t_{f} < 250 µm. If the final thickness of the substrate lies within the range of 120 µm and 250 µm, a tape may be used as the carrier.

In some embodiments, the carrier comprises a temperature stable stiff support carrier, such as glass, sapphire, silicon or similar, that is applied to the front side with adhesive and 20 µm ≤ t_{f} < 250 µm. A glass carrier may be used for final thicknesses lying in the range of 20 µm ≤ t_{f} ≤ 120 µm, 30 µm ≤ t_{f} ≤ 120 µm, and 50 µm ≤ t_{f} ≤ 120 µm, as well as for final thicknesses lying in the range of 120 µm ≤ t_{f} < 250 µm.

The lower limit of the final thickness of the substrate may depend on the material of the substrate. In some embodiments, the substrate is a bulk monocrystalline sapphire substrate and the lower limit of the final thickness may be 20 µm so that 20 µm ≤ t_{f} < 250 µm. In embodiments, in which the substrate is a bulk monocrystalline silicon substrate the lower limit of the final thickness may be higher, for example 50 µm so that 50 µm ≤ t_{f} < 250 µm.

The method according to embodiments described herein can be used to increase the reliability and yield of semiconductor chips from a semiconductor wafer having a diameter of 4 inches to 12 inches, in particular 6 inches to 12 inches. Consequently, the method according to embodiments described herein is useful for commercial-scale production.

In some embodiments, for both a silicon and sapphire substrate, the maximum substrate thickness after the thinning process, i.e. the maximum value of t_{f}, may be 250 µm or 100 µm, also for substrates having a diameter of 4 inches to 12 inches, in particular greater than 6 inches.

Therefore, in some embodiments 20 µm ≤ t_{f} < 100 µm, so that for a bulk monocrystalline sapphire substrate 20 µm ≤ t_{f} < 100 µm and for a bulk monocrystalline silicon substrate 50 µm ≤ t_{f} < 100 µm. For a bulk monocrystalline sapphire substrate having a diameter d_{w}, wherein 4 inches ≤ d_{w} ≤ 12 inches or 6 inches ≤ d_{w} ≤ 12 inches, the final thickness of the substrate t_{f} may be 20 µm ≤ t_{f} < 250 µm or 20 µm ≤ t_{f} < 100 µm. For a bulk monocrystalline silicon substrate having a diameter d_{w}, wherein 4 inches ≤ d_{w} ≤ 12 inches or 6 inches ≤ d_{w} ≤ 12 inches, the final thickness of the substrate t_{f} may be 50 µm ≤ t_{f} < 250 µm or 50 µm ≤ t_{f} < 100 µm.

The worked rear surface of the substrate is characterised by features resulting from the removal process. In some embodiments, the worked rear surface of the substrate has an average surface roughness Rₐ of greater than 1 nm. For comparison, the growth surface of the substrate has an average surface roughness Rₐ of less than 1 nm.

In some embodiments, the method further comprises depositing a metal layer on the worked rear surface. The metal layer may provide a ground plane, and/or improve the bondability of the surface to the die pad of a package, for example. The metal layer may include two or more sublayers which may be deposited using the same or different techniques. For example, a seed layer may be deposited on the silicon material of the worked rear surface by chemical vapour deposition or physical vapour deposition, for example sputtering, and one or more further metallic or metal layers deposited on the seed layer, for example, using electrodeposition. The metal layer and seed layer, if used, may comprise aluminium or copper, for example.

The metal layer may be deposited on the worked rear surface and the carrier removed from the Group III nitride-based layer afterwards, or these steps may be reversed and the carrier is removed from the Group III nitride-based layer first and then, afterwards, the metal layer is deposited on the worked rear surface.

In some embodiments, the method further comprises laminating the worked rear surface onto a dicing tape. In embodiments in which a metal layer is deposited on the worked rear surface, the metal layer is laminated onto the dicing tape.

The method may further comprise separating the semiconductor wafer into individual chips by inserting a cut into the Group III nitride-based layer and through the substrate to separate individual chips from the semiconductor wafer. The Group III nitride-based layer may be substantially planar before inserting the cut.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A Method of fabricating a semiconductor wafer, comprising:
providing a semiconductor wafer comprising a bulk monocrystalline substrate having a growth surface and a rear surface that opposes the growth surface, and an epitaxial Group III nitride-based layer on the growth surface of the substrate the epitaxial Group III nitride-based layer comprising at least one Group III nitride-based device, wherein the substrate has an initial thickness ti and comprises silicon or sapphire;
applying a carrier to the epitaxial Group III nitride-based layer;
removing portions of the rear side of the substrate whilst the carrier is applied to the epitaxial Group III nitride-based layer, reducing the thickness of the substrate to a thickness t_{f} and producing a worked rear surface, wherein t_{f} < tᵢ and 20 µm ≤ t_{f} < 250 µm.

2. The method of claim 1, wherein the removing portions of the rear side of the substrate comprises at least one of the group consisting of grinding, polishing, chemical etching and chemical mechanical polishing.

3. The method of claim 1 or claim 2, wherein the carrier comprises a tape and 120 µm ≤ t_{f} < 250 µm.

4. The method of claim 1 or claim 2, wherein the carrier comprises a glass support that is applied to the epitaxial layer with adhesive, the substrate is a bulk monocrystalline sapphire substrate and 20 µm ≤ t_{f} < 250 µm, or the carrier comprises a glass support that is applied to the epitaxial layer with adhesive, the substrate is a bulk monocrystalline silicon substrate and 50 µm ≤ t_{f} < 250 µm.

5. The method of any one of claims 1 to 4, wherein the Group III nitride layer comprises two or more sublayers of differing composition, wherein two of the sublayers have differing bandgaps and form a heterojunction capable of supporting a two dimensional charge gas.

6. The method of any one of claims 1 to 5, wherein the Group III nitride-based device further includes a metallization structure on the Group III nitride layer and the carrier is applied to the metallization structure.

7. The method of claim 1, wherein the worked rear surface has a surface roughness Ra of greater than 1 nm.

8. The method of one of claims 1 to 7, further comprising depositing a metal layer on the worked rear surface.

9. The method of claim 8, wherein the metal layer is deposited on the worked rear surface and, afterwards the carrier is removed, or the carrier is removed and, afterwards, the metal layer is deposited on the worked rear surface.

10. The method of one of claims 1 to 9, further comprising laminating the worked rear surface onto a dicing tape.

11. The method of claim 10, further comprising separating the semiconductor wafer into individual chips by inserting a cut into the Group III nitride-based layer and through the silicon substrate.

12. A semiconductor wafer, comprising:
a bulk monocrystalline silicon or sapphire substrate comprising a growth surface and a worked rear surface;
an epitaxial Group III nitride-based layer on the growth surface of the bulk monocrystalline substrate, the epitaxial Group III nitride-based layer comprising a Group III nitride-based device;
wherein the semiconductor wafer has a thickness t_{w}, wherein 30 µm ≤ t_{w} ≤ 280 µm.

13. The semiconductor wafer of claim 12, wherein the Group III nitride-based device is a High Electron Mobility Transistor.

14. A semiconductor chip, comprising:
a bulk monocrystalline silicon or sapphire substrate comprising a growth surface and a worked rear surface;
an epitaxial Group III nitride-based layer on the growth surface of the semiconductor substrate, the epitaxial Group III nitride-based layer comprising a Group III nitride-based device;
wherein the semiconductor chip has a thickness t wherein 30 µm ≤ t ≤ 280 µm.

15. A semiconductor component, comprising:
the semiconductor chip of claim 14,
a leadframe having a thickness tₗ, and
a housing,
wherein the semiconductor chip is attached to a die pad of the leadframe and t/tₗ is smaller than 1.3 or greater than 1.9.
